# EUROPEAN PATENT APPLICATION

(11) **EP 4 513 495 A2**
(43) Date of publication of application: **26.02.2025**
(21) Application number: 24191401.9
(22) Date of filing: 29.07.2024
(51) Int. Cl.: G11C 29/44, G11C 29/00

(54) **BAD BLOCK DETECTION IN LOGICAL DRIVES**

(30) Priority: 22.08.2023 US 202318453787
(71) Applicant: Avago Technologies International Sales Pte. Limited, Singapore 768923 (SG)
(72) Inventor: Jana, Arun Prakash, Irvine, 92618 (US); Kori, Sumalatha, Irvine, 92618 (US)
(74) Representative: Dilg, Haeusler, Schindelmann Patentanwaltsgesellschaft mbH

(57) **Abstract**

A device (110) including one or more circuits (115). The one or more circuits (115) can receive a request associated with a first dataset stored by a memory device (125) of a plurality of memory devices (125). The one or more circuits (115) can generate, based on information associated with the memory device (125) and the request, a first value corresponding to a first portion (205) of a first map. The one or more circuits (115) can determine, based on a first value of the first portion (205) of the first map, that a first row (210) of the plurality of rows (210) includes a bad block.

## Description

### BACKGROUND

The present disclosure is related to logical drives. Logical drives and/or components thereof can store data.

### BRIEF DESCRIPTION OF THE DRAWINGS

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.
FIG. 1 is a block diagram of a system for handling bad blocks in memory devices, according to some embodiments.
FIG. 2 is a system including a plurality of portions that define a logical drive, according to some embodiments.
FIG. 3 is a map for use in identifying bad blocks, according to some embodiments.
FIG. 4 is a map for use in associated portions of one or more memory devices, according to some embodiments.
FIG. 5 is a map for use in identifying portions of one or more memory devices, according to some embodiments.
FIG. 6 is a flow diagram of a process for detecting and diverting bad blocks, according to some embodiments.
FIG. 7 is a flow diagram of a process for handling bad blocks, according to some embodiments.

### DETAILED DESCRIPTION

Some embodiments are related to systems and methods for logical drive bad block detection. Logical drives may include at least one of a physical drive, an arm, and/or a portion. Logical drives may also be implemented within and/or included as a physical drive array. Arms of a logical drive can include at least one strip and/or segment. Strips of a logical drive can be oriented and/or otherwise positioned as one or more sequential streams along one or more rows. For example, a first logical drive may include a first arm and a second arm. The first arm and the second arm may include one or more segments positioned as a sequential stream. The sequential stream be included in and/or define one or more rows. As another example, a first segment of a first arm may be followed by a first segment of a second arm and the first segments may follow a sequential stream along a first row.

Physical drives may be damaged during one or more circumstances. For example, physical drives may be damage during a manufacturing process, during various operations, and/or responsive to external forces having been placed on physical drives. Damage caused to physical drives may cause and/or result in the physical drives developing bad blocks. A bad block may refer to and/or include at least one of a bad sector, a portion of the physical drive that no longer provides reliable data storage, and/or an area of the physical drive that has been damaged.

Processing circuits, packet processors, switches, routers, etc. can interact with physical drives and/or logical drives thereof. During interactions with logical drives, bad blocks may be detected on an underlining physical drive. As described herein, logical drives may include segments that are orientated in a sequential stream. During interactions with a sequential stream of segments, an instance of a bad block may be recorded in a register. However, recording the instance of the bad block may not include identifying a given portion of a logical drive. Accordingly, during subsequent interactions involving the sequential stream, one or more messages and/or requests corresponding to segments along the sequential stream may be diverted to a bad block manager. The diversion of the one or more messages may impact an overall performance of a system (e.g., the processing circuit and the logical drives) as some diverted messages may correspond to portions of a logical drive that do not contain a bad block.

Some technical solutions of the present application provide a system including a device that records information to identify portions of logical drives that include detected bad blocks. The device may generate and/or update one or more bitmaps. The device may update the bitmaps based on various interactions described herein. For example, the device may update a first bitmap to indicate bad blocks corresponding to various rows and/or sequential steams. The device may also link a second bitmap to the first bitmap. For example, the device may associate a portion and/or section of the first bitmap within a portion and/or element of the second bitmap. The second bitmap can include values to identify one or more portions of the logical drives. For example, the second bitmap may identify a first arm and a second arm of a logical drive. During interactions with the logical drive, the device may detect that at least one of the first arm and/or the second arm includes a bad block. The device may set a given value, in the first bitmap, to indicate that a given row includes a bad block, and the device may set a given value, in the second bitmap, to indicate a given arm that includes the bad block.

During subsequent interactions with segments of the logical drive, the device may utilize the first bitmap and the second bitmap to identify given messages to divert and given messages to process. For example, the device may receive a message corresponding to a first segment located in a row with a bad block. To continue this example, the device may determine, based on the first bitmap, that the row includes the bad block. Additionally, the device may then check the second bitmap to determine if the first segment is located in an arm that includes the bad block. The device may divert the message responsive to the second bitmap indicating that the arm includes the bad block. The device may process the message responsive to the second bitmap indicating that the arm does not contain a bad block.

The device may be in communication with a host. For example, the device may be in communication with an application that is running on a given operating system and the host may provide one or more requests (e.g., messages) to the device. A host may refer to and/or include switches, routers, and/or other possible packet delivery devices. A host may refer to and/or include a computing system, a computing device, and/or a computer that is running and/or executing an application. The communication between the device and the host may be direct (e.g., the device is directly connected to the host) and/or indirect (e.g., a component receives signals from the host and the component provides the signals to the device), in some embodiments. The communication between the host and the device may include the device and the host being electrically coupled with one another.

The system may refer to and/or include at least one of Application-Specific Integrated Circuits (ASIC), capacitive load components, display drivers, touch screens, keyboard sensors, mobile devices, computing devices, computers, desktops, laptops, and/or among other possible touch controllers. The device may refer to and/or include at least one of an integrated circuit, a general purpose processor, a multicore processor, a software programmable device, a programmable logic controller, and/or among other possible circuitry and/or hardware, in some embodiments. Similarly, the functionality of the device may be stored, in memory, as software and/or as instructions and when the software and/or instructions are executed, by a processor, the processor may perform the functionality of the device.

One or more circuits may refer to and/or include memory and one or more processors, in some embodiments. Memory may store instructions and the one or more processors may execute the instructions, in some embodiments. Processors executing instructions may cause the processors to perform operations based on the instructions, in some embodiments. The one or more circuits may refer to and/or include at least one of an integrated circuit, a general purpose processor, a multicore processor, a software programmable device, a programmable logic controller, and/or among other possible circuitry and/or hardware, in some embodiments.

A request may refer to and/or include at least one of a request to perform a write operation, a request to perform a read operation, a request to access information, a request to provide information, a request to view information, a request to record information, a request to replace information, a request to update information, and/or among various other possible read and/or write operations, in some embodiments.

A map may refer to and/or include at least one of a bitmap, an arm map, a bad block map, a table including one or more bits corresponding to various types of information, a data structure including one or more rows storing various types of information, an array including various types of information, a database storing various types of information, and/or among various other possible data stores, in some embodiments. A segment may refer to and/or include at least one of a logical location of a given piece of information stored in memory, a strip, a collection of bits, a portion of a memory bank, and/or an element included in an array, in some embodiments. A memory device may refer to and/or include at least one of devices for storing data and/or computer code, a logical drive, a physical drive, an array of logical drives, solid state drives, hard-disk drives, hard disk storage, RAM, ROM, Flash memory, DRAM banks, and/or various types of computer storage media, in some embodiments. A portion of a memory device may refer to and/or include at least one of an arm, a drive, a disk drive, and/or among other possible portions, components, and/or elements of drive devices that include a logical drive and/or that are included in an array of a logical drive, in some embodiments.

A section of a map may refer to and/or include at least one of a collection of bits, a row located within the map, a column located within the map, and/or various identifiable aspects of a map, in some embodiments. An element of a map may refer to and/or include at least one of a collection of bits, a row located within the map, a column located within the map, and/or various identifiable aspects of a map, in some embodiments. A dataset may refer to and/or include a collection of information, binary numbers, instructions, variables, values, shared libraries, and/or program code, in some embodiments.

Some embodiments relate to a system. The system can include a memory device. The memory device can include a plurality of portions. The plurality of portions can have a plurality of segments. The plurality of segments can be located in a plurality of rows of the memory device. The system can also include a device. The device can be in communication with the memory device. The device can include one or more circuits. The one or more circuits can receive a request associated with a first dataset stored by the memory device. The first dataset can be located in a first segment of the plurality of segments. The first segment can be included in a first portion of the plurality of portions. The one or more circuits can also generate, based on information associated with the memory device and the request, a first value to identify a first section of a first map. The one or more circuits can also determine, based on a first value of the first section, that a first row of the plurality of rows includes a bad block, and the first segment can be located in the first row of the plurality of rows. The one or more circuits can also identify a first element of a second map based on an associated between the first section and the first element. The one or more circuits can also determine a first value of the first element to identify one or more first portions of the plurality of portions, and divert, responsive to a determination that the one or more first portions include the first portion, the request based on one or more rules to address the bad block.

In some embodiments, the one or more circuits can also receive a second request associated with a second dataset stored by the memory device, the second dataset can be located in a second segment of the plurality of segments, the second segment can be located in the first row, and the second segment can be included in a second portion of the plurality of portions. The one or more circuits can also identify a second element of the second map based on an association between a second section of the first map and the second element. The one or more circuits can also determine a first value of the second element to identify one or more second portions of the plurality of portions, and perform, responsive to a determination that the second portion is absent from the one or more second portions, one or more actions to process the second request.

In some embodiments, the first map can include a plurality of sections and the plurality of sections can have respective values. The second map can include a plurality of elements and the plurality of elements can have respective values. The one or more circuits can also update, responsive to detection of a second bad block, at least one section of the plurality of sections to identify a second row of the plurality of rows including the second bad block, and update at least one element of the plurality of elements to identify one or more second portions of the plurality of portions.

In some embodiments, the first row can include a second segment of the plurality of segments, the second segment can be included in a second portion of the plurality of portions. The first row can also include a third segment of the plurality of segments, the third segment can be included in a third portion of the plurality of portions. The one or more circuits can also perform, responsive to a determination that the second portion is absent from the one or more first portions, one or more actions to process a second request associated with a second dataset located in the second segment, and divert, responsive to a determination that the one or more first portions include the third portion, a third request associated with a third dataset located in the third segment.

In some embodiments, the one or more circuits can receive a second request associated with a second dataset stored by the memory device, the second dataset can be located in a second segment of the plurality of segments, the second segment can be included in a second portion of the plurality of portions, the second segment can be located in a second row of the plurality of rows, and the second row can include at least one bad block. The one or more circuits can also receive a third request associated with a third dataset stored the memory device, the third dataset can be located in a third segment of the plurality of segments, the third segment can be included in a third portion of the plurality of portions, and the third segment can be located in the second row. The one or more circuits can also determine a second value of a second element of the second map to identify one or more second portions of the plurality of portions. The one or more circuits can also divert, responsive to a determination that the one or more second portions include the second portion, the second request based on the one or more rules, and divert, responsive to a determination that the one or more second portions include the third portion, the third request based on the one or more rules.

In some embodiments, a second request can be associated with a second dataset stored by the memory device. The second dataset can be located in a second segment of the plurality of segments, and the second request can be processed by the one or more circuits with the second segment located in the first row of the plurality of rows.

In some embodiments, a second request can be associated with a second dataset stored by the memory device. The second dataset can be located in a second segment of the plurality of segments. The second segment can be included in a second portion of the plurality of portions, and the second request can be diverted by the one or more circuits responsive to a determination that the one or more first portions include the second portion.

In some embodiments, divert, responsive to the determination that the one or more first portions include the first portion, the request based on the one or more rules to address the bad block can include identifying, by the one or more circuits, a given segment of the plurality of segments to locate the first dataset, or providing, by the one or more circuits, the first dataset to a given memory device of a plurality of memory devices.

Some embodiments relate to a device. The device can be in communication with a memory device. The memory device can include a plurality of portions. The plurality of portions can have a plurality of segments located in a plurality of rows of the memory device. The device can include one or more circuits. The one or more circuits can receive a request associated with a first dataset stored by the memory device, the first dataset can be located in a first segment of the plurality of segments, and the first segment can be included in a first portion of the plurality of portions. The one or more circuits can also generate, based on information associated with the memory device and the request, a first value to identify a first section of a first map. The one or more circuits can also determine, based on a first value of the first section, that a first row of the plurality of rows includes a bad block, and the first segment can be located in the first row of the plurality of rows. The one or more circuits can also identify a first element of a second map based on an association between the first section and the first element. The one or more circuits can also determine a first value of the first element to identify one or more first portions of the plurality of portions, and divert, responsive to a determination that the one or more first portions include the first portion, the request based on one or more rules to address the bad block.

In some embodiments, the one or more circuits can receive a second request associated with a second dataset stored by the memory device, the second dataset can be located in a second segment of the plurality of segments, the second segment can be located in the first row, and the second segment can be included in a second portion of the plurality of portions. The one or more circuits can also identify a second element of the second map based on an association between a second section of the first map and the second element. The one or more circuits can also determine a first value of the second element to identify one or more second portions of portions of the plurality of portions, and perform, responsive to a determination that the second portion is absent from the one or more second portions, one or more actions to process the second request.

In some embodiments, the first map can include a plurality of sections and the plurality of sections can have respective values. The second map can include a plurality of elements and the plurality of elements can have respective values. The one or more circuits can also update, responsive to detection of a second bad block, at least one section of the plurality of sections to identify a second row of the plurality of rows including the second bad block, and update at least one element of the plurality of elements to identify one or more second portions of the plurality of portions.

In some embodiments, the first row can include a second segment of the plurality of segments, the second segment can be included in a second portion of the plurality of portions. The first row can also include a third segment of the plurality of segments, the third segment can be included in a third portion of the plurality of portions. The one or more circuits can also perform, responsive to a determination that the second portion is absent from the one or more first portions, one or more actions to process a second request associated with a second dataset located in the second segment, and divert, responsive to a determination that the one or more first portions include the third portion, a third request associated with a third dataset located in the third segment.

In some embodiments, the one or more circuits can receive a second request associated with a second dataset stored by the memory device, the second dataset can be located in a second segment of the plurality of segments, the second segment can be included in a second portion of the plurality of portions, the second segment can be located in a second row of the plurality of rows, and the second row can include at least one bad block. The one or more circuits can also receive a third request associated with a third dataset stored by the memory device, the third dataset can be located in a third segment of the plurality of segments, the third segment can be included in a third portion of the plurality of portions, and the third segment can be located in the second row. The one or more circuits can also determine a second value of a second element of the second map to identify one or more second portions of the plurality of portions. The one or more circuits can also divert, responsive to a determination that the one or more second portions include the second portion, the second request based on the one or more rules, and divert, responsive to a determination that the one or more second portions include the third portion, the third request based on the one or more rules.

In some embodiments, a second request can be associated with a second dataset stored by the memory device. The second dataset can be located in a second segment of the plurality of segments, and the second request can be processed by the one or more circuits with the second segment located in the first row of the plurality of rows.

In some embodiments, a second request can be associated with a second dataset stored by the memory device. The second dataset can be located in a second segment of the plurality of segments. The second segment can be included in a second portion of the plurality of portions, and the second request can be diverted by the one or more circuits responsive to a determination that the one or more first portions include the second portion.

In some embodiments, divert, responsive to the determination that the one or more first portions include the first portion, the request based on the one or more rules to address the bad block can include identifying, by the one or more circuits, a given segment of the plurality of segments to locate the first dataset, or providing, by the one or more circuits, the first dataset to a given memory device of a plurality of memory devices.

Some embodiments relate to a method. The method can include receiving, by one or more circuits, a request associated with a first dataset stored by a memory device. The memory device can include a plurality of portions, the plurality of portions can have a plurality of segments, the plurality of segments can be located in a plurality of rows of the memory device, the first dataset can be located in a first segment of the plurality of segments, and the first segment can be included in a first portion of the plurality of portions. The method can also include generating, by the one or more circuits based on information associated with the memory device and the request, a first value to identify a first section of a first map. The method can also include determining, by the one or more circuits based on a first value of the first section, that a first row of the plurality of rows includes a bad block, and the first segment can be located in the first row of the plurality of rows. The method can also include identifying, by the one or more circuits, a first element of a second map based on an association between the first section and the first element. The method can also include determining, by the one or more circuits, a first value of the first element to identify one or more first portions of the plurality of portions, and diverting, by the one or more circuits responsive to a determination that the one or mor first portions include the first portion, the request based on one or more rules to address the bad block.

In some embodiments, the method can also include receiving, by the one or more circuits, a second request associated with a second dataset stored by the memory device. The second dataset can be located in a second segment of the plurality of segments, the second segment can be located in the first row, and the second segment can be included in a second portion of the plurality of portions. The method can also include identifying, by the one or more circuits, a second element of the second map based on an association between a second section of the first map and the second element. The method can also include determining, by the one or more circuits, a first value of the second element to identify one or more second portions of the plurality of portions, and performing, by the one or more circuits, responsive to a determination that the second portion is absent from the one or more second portions, one or more actions to process the second request.

In some embodiments, the first map can include a plurality of sections having respective values, and the second map can include a plurality of elements having respective values. The method can also include updating, by the one or more circuits responsive to detection of a second bad block, at least one section of the plurality of sections to identify a second row of the plurality of rows including the second bad block, and updating, by the one or more circuits, at least element of the plurality of elements to identify one or more second portions of the plurality of portions.

In some embodiments the first row can include a second segment of the plurality of segments, the second segment can be included in a second portion of the plurality of portions, the first row can include a third segment of the plurality of segments, the third segment can be included in a third portion of the plurality of portions. The method can also include performing, by the one or more circuits responsive to a determination that the second portion is absent from the one or more first portions, one or more actions to process a second request associated with a second dataset located in the second segment, and diverting, by the one or more circuits responsive to a determination that the one or more first portions include the third portion, a third request associated with a third dataset located in the third segment.

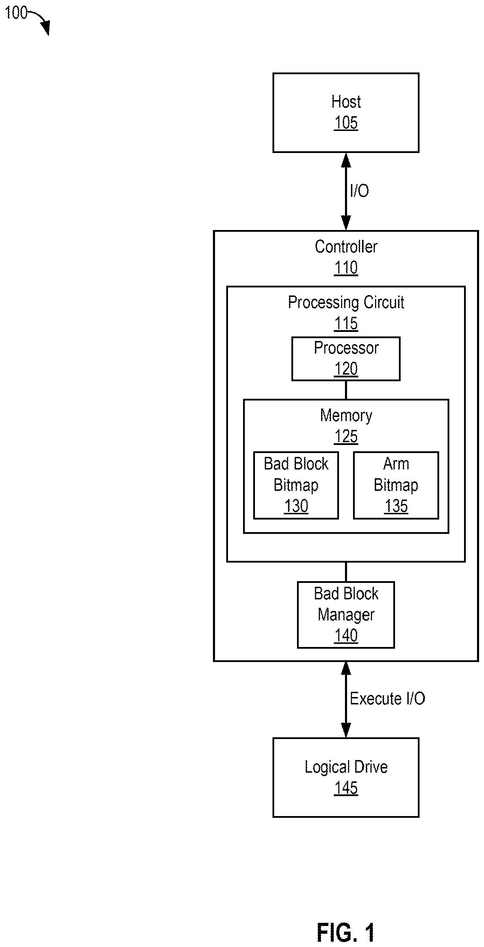

FIG. 1 depicts a block diagram of a system 100, according to some embodiments. The system 100 may include host 105, controller 110, and logical drive 145. In some embodiments, the controller 110 may include and/or be implemented as the device described herein. In some embodiments, the controller 110 may perform operations similar to that of the device described herein. In some embodiments, the host 105 may include the host described herein. In some embodiments, the logical drive 145 may include and/or be implemented as the logical drive described herein.

The controller 110 may be in communication with the host 105. For example, the controller 110 and the host 105 may exchange messages and/or otherwise communicate with one another. For example, the host 105 may provide, to the controller 110, one or more Input/Output (I/O) messages. The I/O messages are illustrated as I/O in FIG. 1. The I/O messages may include and/or refer to the request described herein. For example, the I/O messages may include one or more write operation requests. The controller 110 may be in communication with the logical drive 145. For example, the controller 110 may access and/or provide information to the logical drive 145. In some embodiments, the controller 110 may perform and/or otherwise execute one or more operations to interact with the logical drive 145. For example, the controller 110 may perform given actions based on and/or responsive to receiving one or more I/O messages. As another example, the controller may perform one or more first operations responsive to receiving a write request (e.g., an I/O message). To continue this example, the controller 110 may perform one or more second operations responsive to receiving a read request (e.g., an I/O message).

The controller 110 includes processing circuit 115 and bad block manager 140. The processing circuit 115 and/or circuits 115 may refer to and/or include at least one of the processing circuits, circuitry, circuits, and/or components described herein. The processing circuit 115 includes at least one processor 120 and memory 125. Memory 125 may be and/or include one or more devices (e.g., RAM, ROM, Flash memory, hard disk storage) for storing data and/or computer code. The data and/or computer code may be executed for completing and/or facilitating the various processes described herein. Memory 125 may be or include non-transient volatile memory, non-volatile memory, and non-transitory computer storage media. Memory 125 may include database components, object code components, script components, or any other type of information structure for supporting the various activities and information structures described herein.

Memory 125 may be communicably coupled to the processors 120 and memory 125 may include computer code or instructions (e.g., firmware or software) for executing one or more processes described herein. The processors 120 may be implemented as one or more application specific integrated circuits (ASICs), field programmable gate arrays (FPGAs), a group of processing components, or other suitable electronic processing components. Memory 125 may store one or more instructions that, when executed by the processors 120, cause the processors 120 to perform one or more of the various operations described herein. Memory 125 may store a bad block bitmap 130 and an arm bitmap 135. The bad block bitmap 130 and/or the arm bitmap 135 may refer to and/or include at least one of the various maps described herein.

The bad block manager 140 may perform one or more actions to handle bad blocks. For example, the processing circuit 115 may divert, to the bad block manager 140, one or more I/O messages. In some embodiments, the processing circuit 115 may divert messages that correspond to portions of the logical drive 145 that include bad blocks. In some embodiments, the bad block manager 140 may address the bad block based on one or more rules. For example, the bad block manager 140 may identify and/or otherwise determine one or more subsequent portions and/or segments of the logical drive 145 to utilize in executing the one or more I/O messages. As another example, the bad block manager 140 may identify portions and/or segments of the logical drive 145 that are free and/or otherwise include unutilized memory space.

In some embodiments, the bad block manager 140 may utilize free portions and/or free segments to execute and/or process one or more I/O messages. For example, the bad block manager 140 may locate one or more datasets in portions and/or segments of the logical drive 145. As another example, the bad block manager 140 may identify a given segment of a memory device and the bad block manager 140 may locate a given dataset in the given segment. In some embodiments, the processing circuit 115 may perform similar functionality to that of the bad block manager 140. For example, the processing circuit 115 may address bad blocks based on one or more rules. As another example, the processing circuit 115 may identify free segments located in the logical drive 145.

The logical drive 145 may include one or more logical drives 145. For example, the logical drive 145 may include a plurality of logical drives. As another example, the logical drive 145 may include an array of physical disk drives. In some embodiments, the logical drive 145 may include a redundant array of independent disks (RAID) array. The logical drives 145 may include a plurality of portions. For example, the logical drive 145 may include a first arm (e.g., a first portion) and a second arm (e.g., a second portion). In some embodiments, the plurality of portions of the logical drive 145 may include the portions described herein.

In some embodiments, each portion of the logical drive 145 may include one or more segments. For example, a first arm of the logical drive 145 may include a first segment and a second segment. In some embodiments, segments may refer to and/or include strips. For example, a first segment may be located in a first row and the first segment may be implemented as a strip. In some embodiments, one or more segments may be located in a row. In some embodiments, a row of a memory device may include a plurality of segments. For example, a row may include a first segment and a second segment. In some embodiments, a row may include segments pertaining to various portions of the logical drive 145. For example, a logical drive 145 may include a first portion and a second portion. To continue this example, the first portion and the second portion may both include a first segment. Additionally, the first segments may be located in a given row of a memory device.

The processing circuit 115 may receive one or more requests. For example, the processing circuits 115 may receive one or more I/O messages. As another example, the processing circuit 115 may receive a first request and a second request. The requests may be associated with one or more datasets stored by a memory device. For example, a first request may be associated with a first dataset stored by the logical drive 145 (e.g., a memory device) and a second request may be associated with a second dataset stored by the logical drive 145.

In some embodiments, the processing circuit 115 may receive requests continuously and/or semi continuously. For example, the processing circuit 115 may receive a first request, followed by a second request, and then followed by a third request. In some embodiments, the processing circuit 115 may receive the first request and the processing circuit 115 may then receive, after a given amount of time, the second request. The datasets associated with the one or more requests may be located and/or otherwise associated with one or more segments. For example, a first request may be associated with a first dataset. To continue this example, the first dataset may be located in a first segment. As another example, a second request may be associated with a second dataset and the second dataset may be located in a second segment. In some embodiments, one or more segments may be included in a first portion. For example, a first segment and a second segment may both be located in a first portion of the logical drive 145. As another example, a first segment may be located in a first portion and a second segment may be located in a second portion. To continue this example, the first portion and the second portion may be included in a first logical drive 145.

In some embodiments, the datasets described herein may be located and/or associated with one or more rows of memory. For example, a logical drive 145 may include a first portion and the first portion may include a first segment. To continue this example, the first segment may be located in a first row of memory. As another example, a first segment may be located in a first row and a second segment may be located in a second row. As described herein, a presence of a bad block in a given row of memory may cause messages, that pertain to segments of the given row, to be diverted. The diversion of the messages may occur even when one or more portions do not contain a bad block. For example, a first row of memory may have a bad block. To continue this example, the bad block may be located in a first portion. Messages pertaining to segments that are located in a second portion may be diverted, based on the first row including a bad block. In this example, the processing of messages pertaining to the second portion may be negatively impacted as diverting messages may be more time consuming in relation to just executing the message.

The processing circuit 115 may generate one or more values to identify one or more sections and/or one or more elements of one or more maps. For example, the processing circuit 115 may generate a first value to identify a first section of a first map. As another example, the processing circuit 115 may generate a second value to identify a second section of the first map. In some embodiments, the one or more sections and/or the one or more elements may include portions of the maps. For example, a first map may include a first portion. To continue this example, the first portion may include a first element. In some embodiments, the processing circuit 115 may generate one or more values based on information associated with the requests and the memory devices. For example, the processing circuit 115 may generate, based on information associated with a memory device and a request, a first value to identify a first section of a first map. As another example, the processing circuit 115 may generate a first value to identify a first portion of the first map.

In some embodiments, the first map may refer to and/or include at least one of the various maps described herein. For example, the first map may refer to the bad block bitmap 130. In some embodiments, a value that identifies a section of the first map may refer to and/or include a hash number. In some embodiments, one or more sections of the first map may refer to and/or include one or more bits. For example, the bad block bitmap 130 may include a first section (e.g., a first portion) and a second section. To continue this example, the first section may include bits 0 to 4 of the bad block bitmap 130. In some embodiments, one or more values of the sections may indicate a presence of a bad block. For example, a first section may include three bits and the bits being set (e.g., set to 1) may indicate a presence of a bad block.

In some embodiments, the processing circuit 115 may generate one or more values to identify one or more sections responsive to receiving one or more requests. For example, the processing circuit 115 may generate a first value to identify a first section of a first map based on a first request. To continue this example, the processing circuit 115 may generate a second value to identify a second section of the first map based on a second request.

The processing circuit 115 may determine that one or more rows include a bad block. For example, the processing circuit 115 may determine that a first row includes a bad block. In some embodiments, the processing circuit 115 may determine, based on a first value of a first section of the first map, that a first row includes a bad block. For example, the first value may be associated with bits having values (e.g., 0 or 1) that indicate a presence of a bad block. The first row may include and/or otherwise be associated with one or more segments of the logical drives 145. For example, the first row may include a first segment of one or more logical drives 145. As another example, the first row may include a first segment located in a first portion (e.g., a first arm) of the logical drive 145 and the first row may include a second segment located in a second portion of the logical drive 145.

The processing circuit 115 may identify one or more elements of a second map. For example, the processing circuit 155 may identify a first element and a second element of the second map. In some embodiments, one or more elements of the second map may be associated with the first map. For example, a first section of the first map may be linked to a first element of the second map. To continue this example, the first section may have a given placement in the first map and the first element may have a similar placement in the second map. Additionally, the processing circuit 115 may detect the placement of the first section. In some embodiments, the processing circuit 115 may identify the first element based on the placement of the first section. As another example, a first section of the first map may include a given bit that identifies a first element of the second map. As another example, a placement of the first section in the first map may identify a given row of the second map. In some embodiments, the second map may refer to one or more of the various maps described herein. For example, the second map may refer to the arm bitmap 135.

The processing circuit 115 may determine one or more values of the one or more elements of the second map. For example, the processing circuit 115 may determine a first value of a first element of the second map. As another example, the processing circuit 115 may determine a first value of a second element of the second map. In some embodiments, values of the elements may identify one or more portions. For example, a first element of the second map may represent a first arm and a second arm of the logical drive 145. To continue this example, the first element may have a first value. In some embodiments, the first value may indicate that at least one of the first arm and/or the second arm includes a bad block. In some embodiments, the elements of the second map may identify one or more portions. For example, a first element of the second map may identify one or more portions of the logical drive 145.

In some embodiments, elements of the second map may include one or more bits. The bits may include various values (e.g., 0 or 1) that may indicate and/or identify a presence of a bad block. For example, a logical drive 145 may include 8 portions (e.g., 8 arms). To continue this example, a given bit of the second map may represent arm 0 (e.g., a first portion of the logical drive 145) and a second given bit of the second map may represent arm 1 (e.g., a second portion of the logical drive 145). In some embodiments, the given bit may be set to 1 to indicate a presence of a bad block in arm 0.

The processing circuit 115 may divert one or more requests. For example, the processing circuit 115 may divert requests associated with portions that include bad blocks. As another example, the processing circuit may receive a first message. In some embodiments, the first message may pertain to a first dataset. To continue this example, the first dataset may be located in a first segment. The first segment may be located in an arm that includes a bad block. In some embodiments, the processing circuit 115 may detect, based on a given element of the second map, that the arm include the bad block. Additionally, the processing circuit 115 may divert the first message.

In some embodiments, the processing circuit 115 may divert requests based on one or more rules to address the bad block. For example, the processing circuit 115 may divert, responsive to a determination that one or more first portions include the first portion. In this example, the one or more first portions may be identified by a given bit (e.g., a given element) of the second map. In some embodiments, the one or more first portions may include the first portion. The second map may have a given value to indicate that one or more portions include a bad block. For example, a bit representing the one or more first portions may be set to a 1. The processing circuit 115 may divert the request to the bad block manager 140. For example, the processing circuit 115 may provide an I/O request to the bad block manager 140 and the bad block manager 140 may handle the I/O request.

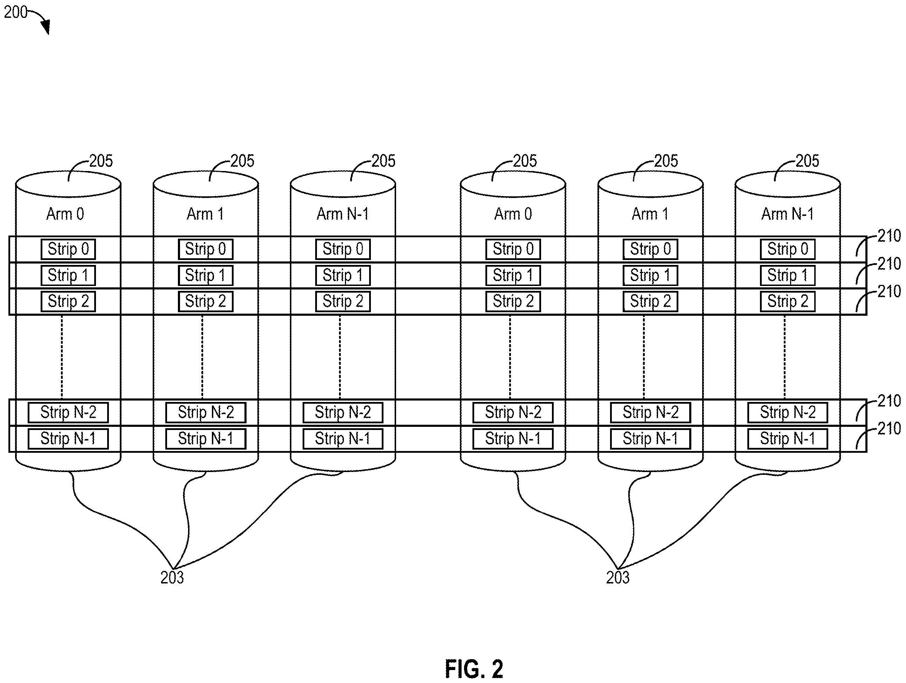

FIG. 2 depicts a system 200, according to some embodiments. The system 200 includes one or more arrays 203. The arrays 203 may refer to and/or include the logical drives 145. For example, a first array 203 may include a first logical drive 145 and a second array 203 may include a second logical drive 145. The arrays 203 include portions 205 and/or arms 205. The arms 205 may refer to and/or include the portions of the memory devices described herein. For example, a first arm 205 may include a first portion of the memory devices. The arms 205 include one or more segments (shown as strip 0, 1, 2, N-2, and N-1 in FIG. 2). For example, a first segment of a first arm 205 may refer to and/or include strip 0. A corresponding strip for a corresponding arm may be included in a corresponding row of memory. For example, FIG. 2 illustrates that Strip 0, for each corresponding arm 205, is included in a first row 210.

In some embodiments, the rows 210 may refer to and/or include the rows described herein. For example, a first row 210 may include a first row of a memory device. In some embodiments, the first row 210 may include a bad block. In some embodiments, a value of a given section of the bad block bitmap 130 may identify that the first row 210 includes the bad block. In some embodiments, the processing circuit 115 may receive a first request associated with a first dataset located in strip 0 (e.g., a first segment) of a first arm 205. Strip 0 of the first arm 205 may be located in the first row 210 (e.g., a row with a bad block). In some embodiments, the processing circuit 115 may generate a value to identify a section of the bad block bitmap 130. The value of the section may indicate the presence of the bad block in the first row 210. For example, the section may include one or more bits and the bits may be set (e.g., 0 or 1) to a given value. In some embodiments, the given value may indicate the presence of the bad block in the first row 210. For example, a given section of the bad block bitmap 130 may be associated with the first row 210. To continue this example, a given value of the section may indicate that the first row 210 includes a bad block.

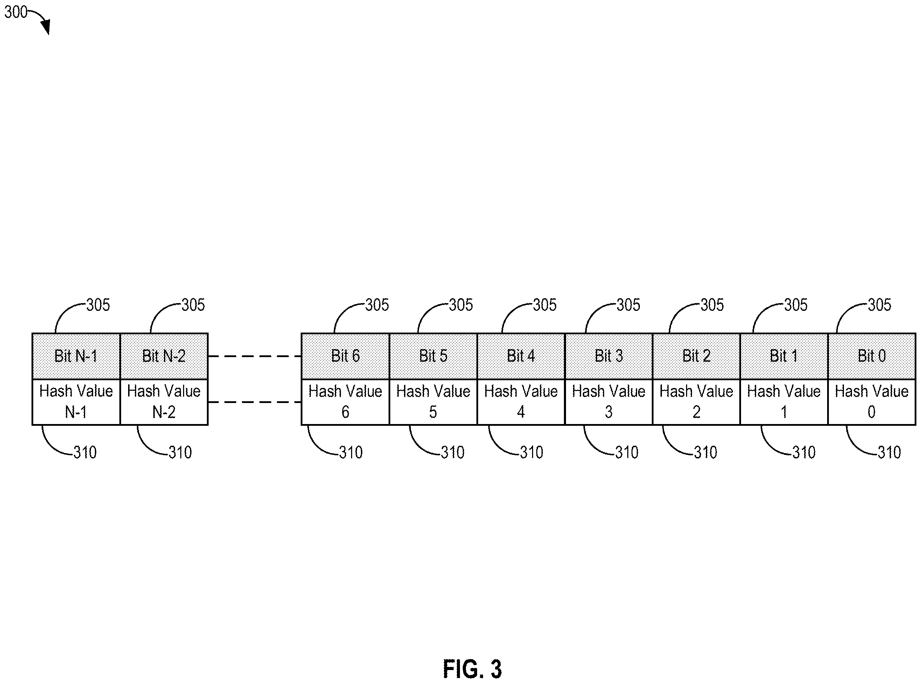

FIG. 3 depicts a map 300, according to some embodiments. In some embodiments, the map 300 may refer to and/or include the bad block bitmap 130. In some embodiments, the map 300 may include at least one of the various maps described herein. The map 300 includes one or more portions 305 and/or one or more sections 305. FIG. 3 depicts an example of the portions 305 corresponding to one or more bits 305. For example, a first portion 305 may correspond to bit 0. In some embodiments, given portions 305 may correspond to one or more bits. For example, the first portion 305 may correspond to bits 0 and bits 1. The bits 305 are shown to include and/or correspond to hash values 310. For example, a first bit 305 and/or a collection of first bits 305 may identify a first hash value 310. In some embodiments, the hash values 310 may refer to and/or include one or more values. In some embodiments, the hash values 310 may identify one or more sections of the first map. For example, the processing circuit 115 may identify, based on a first hash value 310, a first section of the bad block bitmap 130. In some embodiments, the hash values 310 may include values of the one or more sections. For example, a first hash value 310 may identify a first section and the first hash value 310 may be a first value of the first section. To continue this example, the first hash value 310 may have a first value in response to a first row having a bad block and the first value 310 may have a second value in response to the first row not containing bad blocks.

In some embodiments, the processing circuit 115 may update, responsive to detection of a bad block, one or more portions of the map 300. For example, the processing circuit 115 may update a given hash value 310 from a first value (indicating that a given row does not contain a bad block) to a second value (indicated that the given row includes a bad block). The updated hash value 310 may identify that a given row includes the bad block. For example, the processing circuit 115 may set (e.g., set to 1) a given bit when a given row has a bad block and the processing circuit 115 may zero (e.g., set to 0) the given bit when the given row does not contain a bad block.

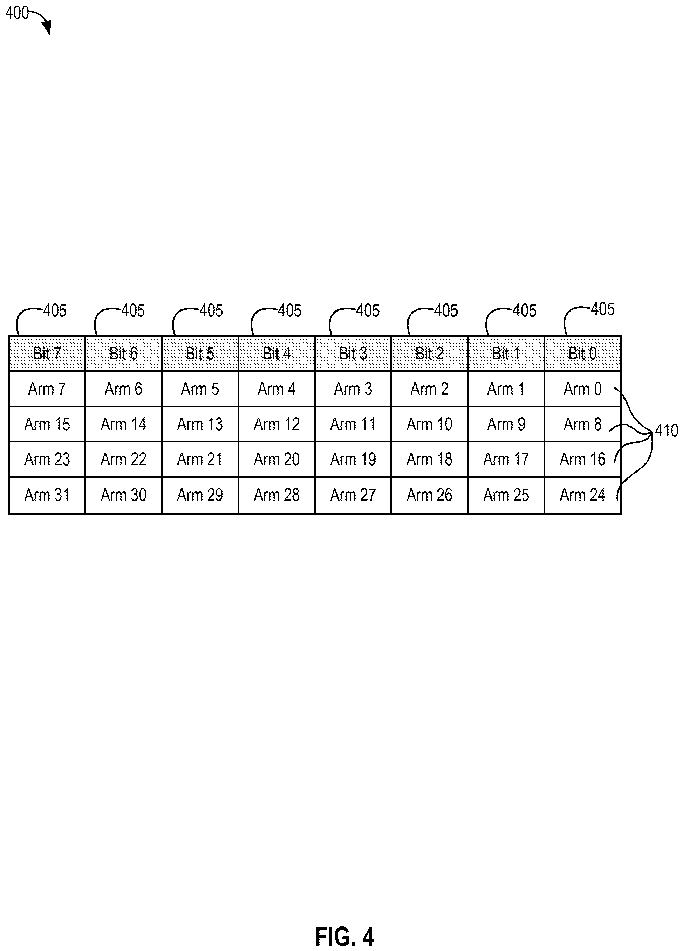

FIG. 4 depicts a map 400, according to some embodiments. The map includes one or more bits 405. In some embodiments, the bits 405 may refer to and/or include the elements of the second map described herein. For example, a first bit 405 may include a first element. In some embodiments, the map 400 may refer to and/or include at least one of the maps described herein. For example, the map 400 may refer to the arm bitmap 135. While FIG. 4 shows the map 400 including eight bits (e.g., bits 0-7), the map 400 may include various numbers of bits. For example, the map 400 may include five bits. As another example, the map 400 may include 15 bits. In some embodiments, the number of bits 405 may correspond to and/or be based on a number of portions for a memory device (e.g., logical drive 145). For example, the logical drive 145 may include eight portions and the map 400 may then include eight bits (e.g., bits 0-7). In some embodiments, respective bits of the map 400 may represent respective portions of the logical drive 145. For example, a first bit 405 may represent a first arm and/or a first portion of a first logical drive 145.

In some embodiments, the bits 405 may represent one or more arms for a logical drive 145. For example, bit 0 (e.g., a first bit 405) is shown to include a collection 410. FIG. 4 shows that the collection 410 includes Arm 0, Arm 8, Arm 16, and Arm 24. As another example, the map 400 may include a second collection 410. To continue this example, the second collection 410 may include and/or represent one or more arms of a logical drive. In some embodiments, the second collection 410 may represent arms of bit 1 (e.g., Arm 1, Arm 9, Arm 17, Arm 25). In some embodiments, Arm 0 may refer to a fist arm of a first logical drive 145, Arm 8 may refer to a ninth arm of the first logical drive 145, Arm 16 may refer to a seventeenth arm of the first logical drive 145, and Arm 24 may refer to a twenty fifth arm of the first logical drive 145. While FIG. 4 depicts the collection 410 including four arms associated with a logical drive 145, the collection 410 may include various numbers of arms. For example, the collection 410 may include 10 arms associated with a logical drive 145.

The map 400 may provide some of the technical solutions described herein. For example, the map 400 is shown to represent and/or include 32 arms and a given bit 405 is shown to represent four arms of the logical drive 145. In some embodiments, the map 400 may represent and/or correspond to logical drives 145 that have various numbers of arms and/or portions. For example, the map 400 may represent and/or include 100 arms for a given logical drive 145. In some embodiments, a given bit 405 may represent various numbers of arms. For example, the map 400 may include five bits 405 and each bit (e.g., bits 0-4) may represent six arms (e.g., a total of 30 arms). As another example, the map 400 may include 10 bits 405 and each bit (e.g., bits 0-9) may represent two arms (e.g., a total of 20 arms).

As described herein, the logical drives 145 may include segments that span and/or are included in one or more rows and a bad block in a given row may result in I/O messages associated with one or more segments of the given row be diverted. The map 400 may prevent I/O messages from being diverted even when the I/O messages are associated with a row that has a bad block. For example, the map 400 may prevent I/O messages associated with one or more portions of a logical drive 145 when only a given portion of the logical drive 145 includes a bad block. To continue this example, the map 400 may prevent I/O messages associated with portions of the logical drives 145 that do not contain bad blocks by recording, in the bits 405, portions (e.g., arms) that have bad blocks. The processing circuit 115 recording, in the map 400, the portions that have bad blocks may result in a diversion of I/O messages that pertain to a portion with a bad block while also processing I/O messages included in the same row.

As a non-limiting example, a system may include a logical drive 145 having 32 arms. In this non-limiting example, each arm (e.g., arms 0-31) may include at least one segment within a given row. To continue this non-limiting example, the segments may refer to a strip (e.g., a strip 0) within a row 210. In this non-limiting example, the processing circuit 115 may detect, via the bad block bitmap 130 and/or the map 300, that a given I/O message (e.g., a request) is associated with a segment that is included in a row (e.g., row 210) that has a bad block. To continue this non-limiting example, the processing circuit 115, without the map 400, may divert the given I/O message even if the bad block is located on an arm that is not associated with the given I/O message. In this non-limiting example, this may result in an increase in the amount of time to process the given I/O message, as the portion associated with the given I/O message does not contain a bad block, however the given I/O message was still diverted. To continue this non-limiting example, subsequent I/O messages that are associated with the given row having the bad block may also be diverted even when the subsequent I/O messages are associated with portions that do not contain the bad block.

In the non-limiting example described above, the diversion of I/O messages that were associated with portions (e.g., arms) of the logical drive 145 that did not contain bad blocks may be referred to as false diversions and/or false diverts (e.g., I/O messages were diverted even when the portions of the logical drives 145 associated with the I/O messages did not contain bad blocks). The map 400 may provide some of the technical solutions described herein by reducing, limiting, and/or preventing false diversions from occurring.

In some embodiments, the processing circuit 115 may detect that a portion (e.g., a given arm) has a bad block. The processing circuit 115 may record, in the map 400, that the portion has the bad block. For example, the processing circuit 115 may detect that arm 0 has a bad block and the processing circuit 115 may then set (e.g., set to 1) a corresponding bit, in the map 400, to reflect the presence of the bad block. The processing circuit 115 recording, in the map 400, the presence of the bad block may prevent the diversion of I/O messages that are associated with a row that has a bad block. For example, the processing circuit 115 may detect, via the bad block bitmap 130, that an I/O message is associated with a row that has a bad block. To continue this example, the processing circuit 115 may then, prior to just diverting the I/O message, check the map 400 to see if the portion associated with the I/O message includes a bad block. In some embodiments, the processing circuit 115 may process the I/O message, responsive to determining that the map 400 indicates that the portion does not contain a bad block. To continue this example, the map 400 prevented a diversion of an I/O message that was associated with a portion that does not contain a bad block.

As a non-limiting example, a system may include 32 arms and each arm may include a single segment located in a single row (e.g., a row includes 32 segments located in respective arms of the 32 arms). In this non-limiting example, the row that includes the 32 segments (e.g., a segment for each 32 arms) may include a bad block. To continue this non-limiting example, the processing circuit 115 may receive I/O messages associated with the 32 segments. In this non-limiting example, the processing circuit 115 may receive a single I/O message for each segment (e.g., 32 I/O messages). To continue this non-limiting example, the processing circuit 115 may detect that the row, including the 32 segments, has a bad block and the processing circuit 115 may divert each of the 32 I/O messages.

In the non-limiting example describe above, the map 400 may reduce the number of I/O messages that are diverted for a given row with a bad block to 12.5 percent. For example, the map 400 may reduce the number of diverted I/O messages from 32 (e.g., the 32 I/O messages) to 4 I/O message (e.g., I/O message associated with one or more elements of a given bit in the map 400). As described above (and in no way limiting), the map 400, as shown in FIG. 4, includes 8 bits and each bit is shown to be associated with 4 arms of a 32-arm system. For example, bit 0 is shown to be associated with arm 0, 8, 16, and 24. To continue this example, the processing circuit 115 may set bit 0 (e.g., set to 1) to indicate that at least one of the arms (e.g., arms 0, 8, 16, 24) includes a bad block. In some embodiments, arms 0, 8, 16, and 24 may refer to and/or include the one or more portions described herein. The processing circuit 115 indicating that at least one of the arms 0, 8, 16, and 24 includes a bad block may reduce the number of I/O messages that are diverted from 32 to 4. For example, the processing circuit 115 may receive the 32 I/O messages (either simultaneously, sequentially, one after the other, etc.) and the processing circuit 115 may detect that the row associated with the 32 I/O messages includes a bad block. To continue this example, the processing circuit 115 may then check the map 400 and determine that bit 0 is set. Furthermore, the processing circuit 115 may then process 28 I/O messages of the 32 I/O messages (e.g., the I/O messages associated with arms other than the arms 0, 8, 16, or 24) and the processing circuit 115 may then divert 4 I/O messages of the 32 I/O messages (e.g., the I/O messages associated with the arm 0, 8, 16, or 24).

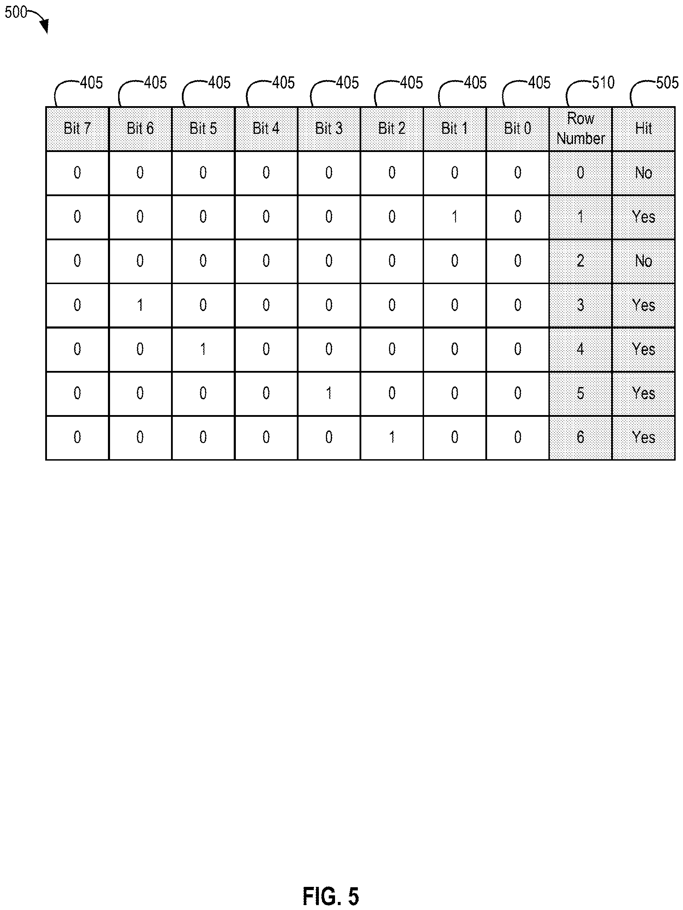

FIG. 5 depicts a map 500, according to some embodiments. In some embodiments, the map 500 may refer to and/or include at least one of the maps described herein. For example, the map 500 may include the arm bitmap 135. In some embodiments, the map 500 may refer to and/or include the map 400. In some embodiments, the map 500 may be an extension of and/or an implementation of the map 400. For example, the map 400 provides an example of how bits may represent arms of logical drives 145 and the map 500 may include an example of the arm bitmap 135 including one or more values. The map 500 includes the bits 405, a hit column and/or hit 505, and a row number column 510 and row number 510. While FIG. 5 shows the map 500 including the bits 405, the number of bits and/or information associated with the bits may be different than that of the bits 405. For example, the map 500 may include 10 bits 405 and the bits 405 may correspond to information that is different from information that identifies a bad block.

In some embodiments, the row number 510 may be associated with and/or otherwise correspond to a given row, a given section of the map 300, a given section of the bad block bitmap 130, a given section of the first map, and/or a given I/O message. For example, row 0 may be associated with a given bit 305 and/or given hash value 310 of the map 300. To continue this example, the processing circuit 115 may determine, based on a request, a hash value and the hash value may include and/or correspond to row 0. Stated otherwise, a given row number of the row number 510 may be linked with a given bit and/or hash value of the map 300.

In some embodiments, the hit 505 may represent and/or otherwise indicate that one or more portions of the logical drives 145 include a bad block. For example, bits 405 associated with row 0 are shown to all be 0 and as such the hit is marked as no (e.g., none of the portions included a detected bad block). As another example, bit 1 of row 1 is shown to be set to 1 and the hit is marked as yes (e.g., a portion includes a detected bad block). As a non-limiting example, bit 1 may indicate that at least one of the arms 1, 9, 17, and/or 25 (as shown in FIG. 4) include a bad block. To continue this example, the processing circuit 115 may divert I/O messages that are associated with row 1 and at least one of arms 1, 9, 17, and/or 25. The processing circuit 115 may process I/O message that are not associated with arms 1, 9, 17, and/or 25.

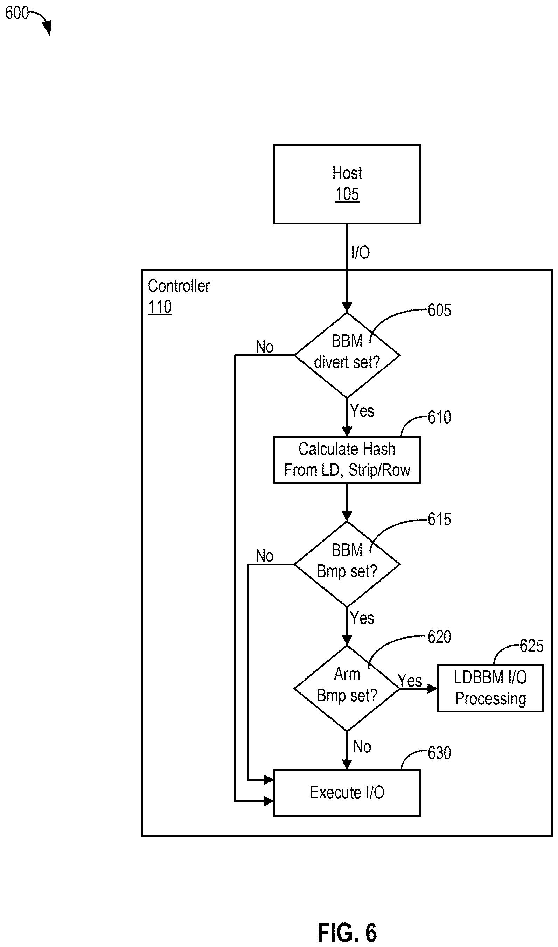

FIG. 6 is a flow diagram of a process 600 for detecting and diverting bad blocks, according to some embodiments. While FIG. 6 shows several steps of the process 600 being performed by the controller 110, at least one step of the process 600 may be performed by one or more devices described herein. For example, the various processing circuits described herein may perform at least one step of the process 600.

At step 605, a determination as to whether an I/O message is included in a divert set may be made. For example, the controller 110 may receive an I/O message. The controller 110 may determine whether the I/O message pertains to logical drives 145 having a bad block. For example, an I/O message may pertain to information stored by a given logical drive 145 and a divert set may be linked to the given logical drive 145. To continue this example, the controller 110 may determine that the I/O message is included in the divert set. The process 600 may proceed to step 630 responsive to the controller 110 determining that the I/O message is absent from the divert set. The process 600 may proceed to step 610 responsive to the controller 110 determining that the I/O message is included in the divert set.

At step 610, a hash value may be calculated from a logical drive and a row number. For example, the controller 110 may determine a hash value based on a logical drive 145 that is associated with the I/O message and a given row including a segment storing information associated with the I/O message.

In some embodiments, the processing circuit 115 may generate one or more values (e.g., one or more hash values). For example, the processing circuit 115 may generate, based on information associated with a memory device and the I/O message, a value to identify a section of a first map. In some embodiments, the first map may refer to and/or include the bad block bitmap 130. The hash value generated in step 610 may refer to and/or include the hash values 310. The process 600 may proceed to step 615 responsive to the generation of the hash value in step 610.

At step 615, a determination as to whether a bad block map (BBM) is set is made. For example, the controller 110 may determine, based on the hash value generated in step 610, that a value of the hash value indicates that the I/O message is associated with a row of the memory device that includes a bad block. As another example, the processing circuit 115 may determine that a value of the hash value generated in step 610 includes and/or indicates a bad block in a given row. In some embodiments, the BBM may refer to and/or include the bad block bitmap 130. For example, the hash value generated in step 610 may include one or more bits in the bad block bitmap 130 and the values (e.g., 0 or 1) may indicate a bad block in a given row. The process 600 may proceed to step 630 responsive to a determination that the BBM is not set (e.g., the I/O message is associated with a row that does not include a bad block). The process 600 may proceed to step 620 responsive to a determination that the BBM is set.

At step 620, a determination as to whether an arm BBM is set is made. For example, the value, determined in step 615, may be linked and/or associated with the arm BBM. The arm BBM may refer to and/or include the arm bitmap 135. The controller 110 may determine that the arm BBM is set responsive to identifying and/or detecting that an element of the arm BBM indicates that the I/O message is associated with an arm that has a bad block. For example, the controller 110 may determine that a bit 405 of the map 500 is set to 1 (e.g., an arm includes a bad block). As another example, the controller 110 may determine that a bit 405 is set to 0 (e.g., an arm does not contain a bad block). To continue this example, the I/O message may be associated with a row of memory that includes a bad block, however the portion associated with the I/O does not contain the bad block. The process 600 may proceed to step 625 responsive to a determination that the arm BBM is set. The process may proceed to step 630 responsive to a determination that the arm BBM is not set.

At step 625, a Logical Drive Bad Block Manager (LDBBM) may process the I/O message that may have been diverted in step 620. For example, the controller 110 may divert an I/O message responsive to the controller 110 determining, in step 620, that an element of the arm BBM is set. The controller 110 diverting the I/O message after step 620 (e.g., after determining that the arm BBM is set) may provide some of the technical solutions described herein. For example, at step 615, a determination may be made that an I/O message is associated with a row that has a bad block, however the I/O message is only diverted following a determination, in step 620, that the arm BBM is set. This two-step process may reduce some of the false diversions described herein. The processing of the I/O messages by the LDBBM may include the LDBBM performing actions similar to that of the bad block manager 140. In some embodiments, the I/O messages may be diverted to the bad block manager 140 and the bad block manager 140 may process the I/O messages.

At step 630, the I/O message may be executed. For example, the I/O message may be a read request and the controller 110 may access information stored in the logical drives 145. The controller 110 may then provide the accessed information to the host 105. As another example, the I/O message may be a write request and the controller 110 may write information to the logical drive 145.

While the process 600 has been described with respect to an I/O message, it should be understood that the process 600 may be performed with one or more I/O messages and that the steps of the process 600 may be performed one after another, in unison, and/or among various other possibilities. For example, the controller 110 may perform step 610 with respect to a first I/O message while also performing step 605 with respect to a second I/O message.

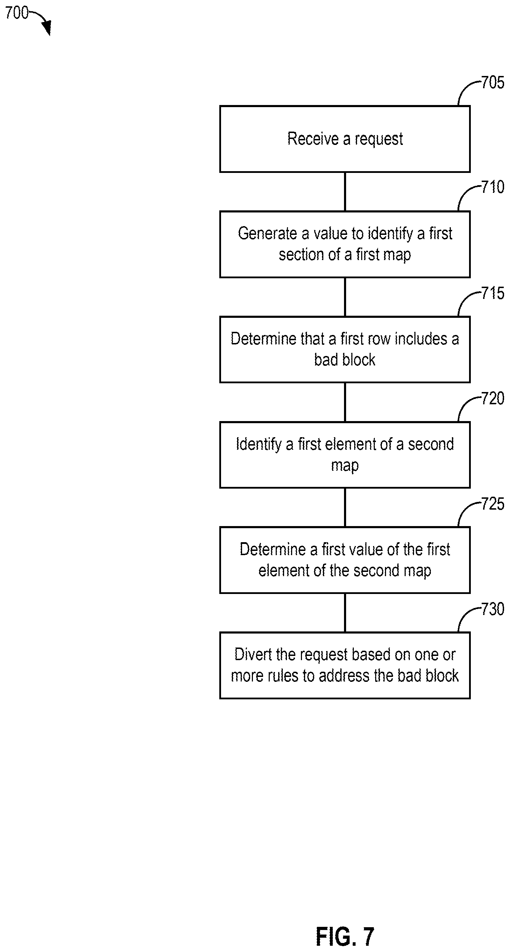

FIG. 7 is a flow diagram of a process 700 for handling bad blocks, according to some embodiments. In some embodiments, the process 700 may be performed by one or more components and/or devices of the system 100. For example, the controller 110 may perform one or more steps of the process 700. As another example, the processing circuit 115 may perform one or more steps of the process 700.

At step 705, a request may be received, in some embodiments. For example, the processing circuit 115 may receive a request from the host 105. The request may include an I/O message. For example, the request may be at least one of the various I/O messages described herein. As another example, the request may be at least one of the various messages and/or requests described herein. In some embodiments, the processing circuit 115 may receive one or more requests. For example, the processing circuit 115 may receive a first request and a second request.

In some embodiments, the requests received by the processing circuit 115 may be associated with one or more datasets. For example, a first request may be associated with a first dataset and a second request may be associated with a second dataset. In some embodiments, the datasets may be stored by a memory device. For example, the datasets may be stored by the logical drive 145 and/or a physical drive including the logical drive 145. In some embodiments, the requests may be associated with a similar dataset. For example, a first request may be associated with a first dataset and a second request may also be associated with the first dataset. In some embodiments, the datasets may be located within one or more segments of the memory devices. For example, a first dataset may be located within a first segment of a first logical drive 145 and a second dataset may be located in a second segment of the first logical drive 145.

In some embodiments, the segments may be located in different portions. For example, a first segment may be located within a first portion of a logical drive 145 and a second segment may be located within a second portion of the logical drive 145. In some embodiments, the segments may be located within similar portions. For example, a first segment and a second segment may be located in a first portion of the logical drive 145. In some embodiments, the segments may be located in one or more rows. For example, the logical drives 145 may include one or more segments and the segments may be located within respective rows 210.

At step 710, a value to identify a first section of a first map may be generated, in some embodiments. For example, the processing circuit 115 may generate a value to identify a section of the bad block bitmap 130. To continue this example, the value may be and/or include a hash value (e.g., hash value 310). In some embodiments, the hash value may be generated based on information associated with a memory device and the request. For example, the processing circuit 115 may generate the hash value based on an identification of a logical drive 145 and a dataset associated with the request. The hash value generated by the processing circuit 115 may specify and/or identity a given section of the bad block bitmap 130.

In some embodiments, the processing circuit 115 may generate values to identify one or more sections of a first map responsive to the processing circuit 115 receiving subsequent requests. For example, the processing circuit 115 may generate a first value responsive to receiving a first request and the processing circuit 115 may generate a second value responsive to receiving a second request.

At step 715, a first row that includes a bad block may be determined, in some embodiments. For example, the value generated in step 710 may identify a given section of the first map and the given section may include a first value. To continue this example, the first value of the first section may indicate that a given row includes a bad block. In some embodiments, the first value of the first section may include a collection of bits and values of the bits (e.g., 0's or l's) may indicate a presence of a bad block. For example, the first section of the first map may include a bad block bit. To continue this example, the bad block bit may be set (e.g., set to 1) and the bad block bit having been set may indicate a bad block. As another example, the first section may include at least one of the bits 305 and the value of the first section may include values that the bits have been set to.

At step 720, a first element of a second map may be identified, in some embodiments. For example, the processing circuit 115 may identify an element of the arm bitmap 135. In some embodiments, the processing circuit 115 may identify the element based on an association with the bad block bitmap 130. For example, the value of the section, identified in step 715, may be associated with and/or linked to a given element of the second map. To continue this example, the value of the section may include a collection of bits that identifies the given element of the second map.

At step 725, a first value of the first element of the second map may be determined, in some embodiments. For example, the processing circuit 115 may examine, analyze, and/or otherwise review the first element of the second map to determine the first value. For example, the processing circuit 115 may determine the first value by reviewing values of the bits included in the first element. As another example, the first value of the first element may include a value of at least one of the bits 405.

In some embodiments, the processing circuit 115 may use the first value identified in step 725 to identify one or more portions. For example, the second map may include the map 400 and the map 400 includes the bits 405. To continue this example, a given bit 405 may identify one or more arms (e.g., portions of memory devices). In some embodiments, the processing circuit 115 may identify the one or more portions by determining that a given bit 405 is set. For example, the processing circuit 115 may determine that bit 0 of the map 400 is set. To continue this example, the processing circuit 115 may then identify arms 0, 8, 16, and/or 24 (e.g., one or more portions). As described herein, a given bit of the map 400 being set may indicate that at least one of the arms associated with the given bit includes a bad block.

At step 730, the request may be diverted based on one or more rules, in some embodiments. For example, the processing circuit 115 may divert the request received in step 705. The processing circuit 115 may diver the request responsive to determining that the one or more portions (as determined in step 725) includes the portion that the request is associated with. Stated otherwise, the request received in step 705 may be associated with a given dataset. The dataset may be located in a given portion of a memory device and the processing circuit 115 may determine, based on the first value determined in step 725, that the given portion of the memory device includes a bad block. In some embodiments, the processing circuit 115 may divert the request responsive to determining that the request is associated with a dataset that is located within a portion having a bad block.

In some embodiments, at least one of the steps of the process 700 may be repeated and/or executed responsive to the processing circuit 115 receiving subsequent requests. For example, the processing circuit 115 may perform steps 710-725 responsive to the processing circuit 115 receiving a second request.

The hardware systems described herein may be implemented in many different ways and in many different combinations of hardware and software and circuit designs. For example, all or parts of the implementations may be circuitry that includes an instruction processor, such as a Central Processing Unit (CPU), microcontroller, or a microprocessor; an Application Specific Integrated Circuit (ASIC), Programmable Logic Device (PLO), or Field Programmable Gate Array (FPGA); or circuitry that includes discrete logic or other circuit components, including analog circuit components, digital circuit components or both; or any combination thereof. The circuitry may include discrete interconnected hardware components and/or may be combined on a single integrated circuit die, distributed among multiple integrated circuit dies, or implemented in a Multiple Chip Module (MCM) of multiple integrated circuit dies in a common package, as examples. In some embodiments, the circuitry can be provided on one or more integrated circuit dies in an integrated circuit package. The integrated circuit package can be a combination of two or more packages in some embodiments.

The circuitry may further include or access instructions (e.g., software or firmware) for execution by the circuitry. The instructions may be stored in a tangible storage medium that is other than a transitory signal, such as a flash memory, a Random Access Memory (RAM), a Read Only Memory (ROM), an Erasable Programmable Read Only Memory (EPROM); or on a magnetic or optical disc, such as a Compact Disc Read Only Memory (CDROM), Hard Disk Drive (HOD), or other magnetic or optical disk; or in or on another machine-readable medium. A product, such as a computer program product, may include a storage medium and instructions stored in or on the medium, and the instructions when executed by the circuitry in a device may cause the device to implement any of the processing described above or illustrated in the drawings.

The implementations may be distributed as circuitry among multiple system components, such as among multiple processors and memories, optionally including multiple distributed processing systems. Parameters, databases, and other data structures may be separately stored and managed, may be incorporated into a single memory or database, may be logically and physically organized in many different ways, and may be implemented in many different ways, including as data structures such as linked lists, hash tables, arrays, records, objects, or implicit storage mechanisms. Programs may be parts (e.g., subroutines) of a single program, separate programs, distributed across several memories and processors, or implemented in many different ways, such as in a library, such as a shared library (e.g., a Dynamic Link Library (DLL)). The DLL, for example, may store instructions that perform any of the processing described above or illustrated in the drawings, when executed by the circuitry.

The term "coupled" and variations thereof includes the joining of two members directly or indirectly to one another. The term "electrically coupled" and variations thereof includes the joining of two members directly or indirectly to one another through conductive materials (e.g., metal or copper traces). Such joining may be stationary (e.g., permanent or fixed) or moveable (e.g., removable or releasable). Such joining may be achieved with the two members coupled directly with or to each other, with the two members coupled with each other using a separate intervening member and any additional intermediate members coupled with one another, or with the two members coupled with each other using an intervening member that is integrally formed as a single unitary body with one of the two members. If "coupled" or variations thereof are modified by an additional term (e.g., directly coupled), the generic definition of "coupled" provided above is modified by the plain language meaning of the additional term (e.g., "directly coupled" means the joining of two members without any separate intervening member), resulting in a narrower definition than the generic definition of "coupled" provided above. Such coupling may be mechanical, electrical, or fluidic.

The foregoing outlines features of several embodiments so that those skilled in the art may better understand the aspects of the present disclosure. Those skilled in the art should appreciate that they may readily use the present disclosure as a basis for designing or modifying other processes and structures for carrying out the same purposes and/or achieving the same advantages of the embodiments introduced herein. Those skilled in the art should also realize that such equivalent constructions do not depart from the spirit and scope of the present disclosure, and that they may make various changes, substitutions, and alterations herein without departing from the spirit and scope of the present disclosure.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first device and a second device) temporally or according to a sequence, although in some cases, these entities can include such a relationship. Nor do these terms limit the number of possible entities that can operate within a system or environment. It should be understood that the systems described above can provide multiple ones of any or each of those components and these components can be provided on either a standalone machine or, in some embodiments, on multiple machines in a distributed system. In addition, the systems and methods described above can be provided as one or more computer-readable programs or executable instructions embodied on or in one or more articles of manufacture, e.g., a floppy disk, a hard disk, a CD-ROM, a flash memory card, a PROM, a RAM, a ROM, or a magnetic tape. The programs can be implemented in any programming language, such as LISP, PERL, C, C++, C#, or in any byte code language such as JAVA. The software programs or executable instructions can be stored on or in one or more articles of manufacture as object code.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

## Claims

1. A system (100), comprising:
a memory device (125) including a plurality of portions (205), the plurality of portions (205) having a plurality of segments located in a plurality of rows (210) of the memory device (125); and
a device (110) in communication with the memory device (125), the device (110) comprising:
one or more circuits (115) configured to:
receive a request associated with a first dataset stored by the memory device (125), the first dataset located in a first segment of the plurality of segments, and the first segment included in a first portion (205) of the plurality of portions (205);
generate, based on information associated with the memory device (125) and the request, a first value to identify a first section of a first map;
determine, based on a first value of the first section, that a first row (210) of the plurality of rows (210) includes a bad block, and wherein the first segment is located in the first row (210) of the plurality of rows (210);
identify a first element of a second map based on an association between the first section and the first element;
determine a first value of the first element to identify one or more first portions (205) of the plurality of portions (205); and
divert, responsive to a determination that the one or more first portions (205) include the first portion (205), the request based on one or more rules to address the bad block.

2. The system (100) of claim 1, further comprising:
the one or more circuits (115) further configured to:
receive a second request associated with a second dataset stored by the memory device (125), the second dataset located in a second segment of the plurality of segments, the second segment located in the first row (210), and the second segment included in a second portion (205) of the plurality of portions (205);
identify a second element of the second map based on an association between a second section of the first map and the second element;
determine a first value of the second element to identify one or more second portions (205) of the plurality of portions (205); and
perform, responsive to a determination that the second portion (205) is absent from the one or more second portions (205), one or more actions to process the second request.

3. The system (100) of claim 1 or 2, further comprising:
the first map including a plurality of sections and the plurality of sections having respective values;
the second map including a plurality of elements and the plurality of elements having respective values; and
the one or more circuits (115) further configured to:
update, responsive to detection of a second bad block, at least one section of the plurality of sections to identify a second row (210) of the plurality of rows (210) including the second bad block; and
update at least one element of the plurality of elements to identify one or more second portions (205) of the plurality of portions (205).

4. The system (100) of any of claims 1 to 3, further comprising:
the first row (210) including:
a second segment of the plurality of segments, the second segment included in a second portion (205) of the plurality of portions (205); and
a third segment of the plurality of segments, the third segment included in a third portion (205) of the plurality of portions (205); and
the one or more circuits (115) further configured to:
perform, responsive to a determination that the second portion (205) is absent from the one or more first portions (205), one or more actions to process a second request associated with a second dataset located in the second segment; and
divert, responsive to a determination that the one or more first portions (205) include the third portion (205), a third request associated with a third dataset located in the third segment.

5. The system (100) of any of claims 1 to 4, further comprising:
the one or more circuits (115) further configured to:
receive a second request associated with a second dataset stored by the memory device (125), the second dataset located in a second segment of the plurality of segments, the second segment included in a second portion (205) of the plurality of portions (205), the second segment located in a second row (210) of the plurality of rows (210), and wherein the second row (210) includes at least one bad block;
receive a third request associated with a third dataset stored the memory device (125), the third dataset located in a third segment of the plurality of segments, the third segment included in a third portion (205) of the plurality of portions (205), and the third segment located in the second row (210);
determine a second value of a second element of the second map to identify one or more second portions (205) of the plurality of portions (205);
divert, responsive to a determination that the one or more second portions (205) include the second portion (205), the second request based on the one or more rules; and
divert, responsive to a determination that the one or more second portions (205) include the third portion (205), the third request based on the one or more rules.

6. The system (100) of any of claims 1 to 5, wherein:
a second request is associated with a second dataset stored by the memory device (125);
the second dataset is located in a second segment of the plurality of segments; and
the second request is processed by the one or more circuits (115) with the second segment located in the first row (210) of the plurality of rows (210).

7. The system (100) of any of claims 1 to 6, wherein:
a second request is associated with a second dataset stored by the memory device (125);
the second dataset is located in a second segment of the plurality of segments;
the second segment is included in a second portion (205) of the plurality of portions (205); and
the second request is diverted by the one or more circuits (115) responsive to a determination that the one or more first portions (205) include the second portion (205).

8. The system (100) of any of claims 1 to 7, wherein divert, responsive to the determination that the one or more first portions (205) include the first portion (205), the request based on the one or more rules to address the bad block includes:
identifying, by the one or more circuits (115), a given segment of the plurality of segments to locate the first dataset; or
providing, by the one or more circuits (115), the first dataset to a given memory device (125) of a plurality of memory devices (125).

9. A device (110) in communication with a memory device (125), the memory device (125) including a plurality of portions (205), the plurality of portions (205) having a plurality of segments located in a plurality of rows (210) of the memory device (125), the device (110) comprising:
one or more circuits (115) configured to:
receive a request associated with a first dataset stored by the memory device (125), the first dataset located in a first segment of the plurality of segments, and the first segment included in a first portion (205) of the plurality of portions (205);
generate, based on information associated with the memory device (125) and the request, a first value to identify a first section of a first map;
determine, based on a first value of the first section, that a first row (210) of the plurality of rows (210) includes a bad block, and wherein the first segment is located in the first row (210) of the plurality of rows (210);
identify a first element of a second map based on an association between the first section and the first element;
determine a first value of the first element to identify one or more first portions (205) of the plurality of portions (205); and
divert, responsive to a determination that the one or more first portions (205) include the first portion (205), the request based on one or more rules to address the bad block.

10. The device (110) of claim 9, comprising at least one of the following features:
the one or more circuits (115) further configured to:
receive a second request associated with a second dataset stored by the memory device (125), the second dataset located in a second segment of the plurality of segments, the second segment located in the first row (210), and the second segment included in a second portion (205) of the plurality of portions (205);
identify a second element of the second map based on an association between a second section of the first map and the second element;
determine a first value of the second element to identify one or more second portions (205) of portions of the plurality of portions (205); and
perform, responsive to a determination that the second portion (205) is absent from the one or more second portions (205), one or more actions to process the second request;
wherein:
the first map includes a plurality of sections and the plurality of sections having respective values;
the second map includes a plurality of elements and the plurality of elements having respective values; and
the one or more circuits (115) are further configured to:
update, responsive to detection of a second bad block, at least one section of the plurality of sections to identify a second row (210) of the plurality of rows (210) including the second bad block; and
update at least one element of the plurality of elements to identify one or more second portions (205) of the plurality of portions (205).

11. The device (110) of claim 9 or 10, wherein:
the first row (210) includes:
a second segment of the plurality of segments, the second segment included in a second portion (205) of the plurality of portions (205); and
a third segment of the plurality of segments, the third segment included in a third portion (205) of the plurality of portions (205); and
the one or more circuits (115) further configured to:
perform, responsive to a determination that the second portion (205) is absent from the one or more first portions (205), one or more actions to process a second request associated with a second dataset located in the second segment; and
divert, responsive to a determination that the one or more first portions (205) include the third portion (205), a third request associated with a third dataset located in the third segment.

12. The device (110) of any of claims 9 to 11, the one or more circuits (115) further configured to:
receive a second request associated with a second dataset stored by the memory device (125), the second dataset located in a second segment of the plurality of segments, the second segment included in a second portion (205) of the plurality of portions (205), the second segment located in a second row (210) of the plurality of rows (210), and wherein the second row (210) includes at least one bad block;
receive a third request associated with a third dataset stored by the memory device (125), the third dataset located in a third segment of the plurality of segments, the third segment included in a third portion (205) of the plurality of portions (205), and the third segment located in the second row (210);
determine a second value of a second element of the second map to identify one or more second portions (205) of the plurality of portions (205);
divert, responsive to a determination that the one or more second portions (205) include the second portion (205), the second request based on the one or more rules; and
divert, responsive to a determination that the one or more second portions (205) include the third portion (205), the third request based on the one or more rules.

13. The device (110) of any of claims 9 to 12, comprising at least one of the following features:
wherein:
a second request is associated with a second dataset stored by the memory device (125);
the second dataset is located in a second segment of the plurality of segments; and
the second request is processed by the one or more circuits (115) with the second segment located in the first row (210) of the plurality of rows (210);
wherein:
a second request is associated with a second dataset stored by the memory device (125);
the second dataset is located in a second segment of the plurality of segments;
the second segment is included in a second portion (205) of the plurality of portions (205); and
the second request is diverted by the one or more circuits (115) responsive to a determination that the one or more first portions (205) include the second portion (205);
wherein divert, responsive to the determination that the one or more first portions (205) include the first portion (205), the request based on the one or more rules to address the bad block includes:
identifying, by the one or more circuits (115), a given segment of the plurality of segments to locate the first dataset; or
providing, by the one or more circuits (115), the first dataset to a given memory device (125) of a plurality of memory devices (125).

14. A method, comprising:
receiving, by one or more circuits (115), a request associated with a first dataset stored by a memory device (125) comprising a plurality of portions (205), the plurality of portions (205) having a plurality of segments, the plurality of segments located in a plurality of rows (210) of the memory device (125), the first dataset located in a first segment of the plurality of segments, and the first segment included in a first portion (205) of the plurality of portions (205);
generating, by the one or more circuits (115) based on information associated with the memory device (125) and the request, a first value to identify a first section of a first map;
determining, by the one or more circuits (115) based on a first value of the first section, that a first row (210) of the plurality of rows (210) includes a bad block, and wherein the first segment is located in the first row (210) of the plurality of rows (210);
identifying, by the one or more circuits (115), a first element of a second map based on an association between the first section and the first element;
determining, by the one or more circuits (115), a first value of the first element to identify one or more first portions (205) of the plurality of portions (205); and
diverting, by the one or more circuits (115) responsive to a determination that the one or mor first portions (205) include the first portion (205), the request based on one or more rules to address the bad block.

15. The method of claim 14, comprising at least one of the following features:
further comprising:
receiving, by the one or more circuits (115), a second request associated with a second dataset stored by the memory device (125), the second dataset located in a second segment of the plurality of segments, the second segment located in the first row (210), and the second segment included in a second portion (205) of the plurality of portions (205);
identifying, by the one or more circuits (115), a second element of the second map based on an association between a second section of the first map and the second element;
determining, by the one or more circuits (115), a first value of the second element to identify one or more second portions (205) of the plurality of portions (205); and
performing, by the one or more circuits (115), responsive to a determination that the second portion (205) is absent from the one or more second portions (205), one or more actions to process the second request;
wherein the first map includes a plurality of sections having respective values, wherein the second map includes a plurality of elements having respective values, and further comprising:
updating, by the one or more circuits (115) responsive to detection of a second bad block, at least one section of the plurality of sections to identify a second row (210) of the plurality of rows (210) including the second bad block; and
updating, by the one or more circuits (115), at least element of the plurality of elements to identify one or more second portions (205) of the plurality of portions (205);
wherein the first row (210) includes a second segment of the plurality of segments, wherein the second segment is included in a second portion (205) of the plurality of portions (205), wherein the first row (210) includes a third segment of the plurality of segments, wherein the third segment is included in a third portion (205) of the plurality of portions (205), and further comprising:
performing, by the one or more circuits (115) responsive to a determination that the second portion (205) is absent from the one or more first portions (205), one or more actions to process a second request associated with a second dataset located in the second segment; and
diverting, by the one or more circuits (115) responsive to a determination that the one or more first portions (205) include the third portion (205), a third request associated with a third dataset located in the third segment.
